# EUROPÄISCHE PATENTSCHRIFT

(11) **EP 0 627 760 B1**
(45) Veröffentlichungstag und Bekanntmachung des Hinweises auf die Patenterteilung: **08.09.1999**
(21) Anmeldenummer: 94107882.6
(22) Anmeldetag: 21.05.1994
(51) Int. Cl.: H01L 21/00, B28D 5/00, H01L 21/48

(54) **Mehrfach-Substrat sowie Verfahren zu seiner Herstellung**
Subdivisible substrate and method of making the same
Substrat subdivisible et son procédé de fabrication

(30) Priorität: 03.06.1993 DE 4318484; 16.06.1993 DE 4319944
(43) Veröffentlichungstag der Anmeldung: 07.12.1994
(73) Patentinhaber: Schulz-Harder, Jürgen, Dr.-Ing., D-91207 Lauf (DE)
(72) Erfinder: Schulz-Harder, Jürgen, Dr.-Ing., D-91207 Lauf (DE)
(74) Vertreter: Graf, Helmut, Dipl.-Ing.

(56) Entgegenhaltungen:
- EP-A- 0 149 923
- DE-A- 2 213 115
- DE-A- 3 906 690
- DE-A- 3 939 794
- US-A- 3 926 746
- US-A- 3 994 430
- US-A- 3 997 964
- US-A- 4 922 326
- PATENT ABSTRACTS OF JAPAN vol. 4, no. 181 (E-037) 13. Dezember 1980 & JP-A-55 124 243 (NEC CORP) 25. September 1980

## Beschreibung

Die Erfindung bezieht sich auf ein Mehrfach-Substrat gemäß dem Oberbegriff des Patentanspruches 1 sowie auf ein Verfahren zum Herstellen eines solchen Mehrfach-Substrates gemäß dem Oberbegriff des Patentanspruches 12.

Bekannt sind Keramik-Metall-Substrate, und dabei insbesondere auch Keramik-Kupfer-Substrate. Diese Substrate werden zum Herstellen von elektrischen Schaltkreisen, insbesondere Leistungsschaltkreisen verwendet. Derartige Substrate weisen eine Kupferschicht auf, die an beiden Oberflächenseiten jeweils mit einer Metallisierung versehen ist, von denen z.B. die Metallisierung an der Oberseite der Keramikschicht z.B. unter Anwendung einer Ätz-Technik strukturiert wird, so daß diese Metallisierung dann die für den jeweiligen Schaltkreis erforderlichen Leiterbahnen, Kontaktflächen usw. bildet. Für eine rationelle Fertigung von elektronischen Schaltkreisen ist es auch bekannt, die Herstellung solcher Schaltkreise im Mehrfach-Nutzen, d.h. als Mehrfach-Substrat vorzunehmen.

Ein bekanntes Mehrfach-Substrat (EP 0 149 923-A2) besteht aus einer Keramikschicht, die eine Vielzahl von Einzelsubstraten bildet, die zeilen- und spaltenmäßig parallel zu senkrecht zueinander verlaufenden Umfangsseiten der Keramikschicht vorgesehen und jeweils von einer Sollbruchlinie in der Keramikschicht voneinander getrennt sind. An der Keramikschicht ist weiterhin entlang ihres gesamten Randes ein Randbereich gebildet, der außerhalb des von den Einzelsubstraten eingenommenen Teils der Keramikschicht liegt und durch eine weitere äußere Sollbruchlinie definiert ist, die entlang des jeweiligen Randbereichs verläuft. Die Sollbruchlinien sind bei diesem bekannten Mehrfach-Substrat von Perforationen in der Keramikschicht gebildet.

Ein solches Mehrfach-Substrat gestattet eine rationelle Fertigung von elektrischen Schaltkreisen, wobei insbesondere die Strukturierung der Metallflächen der Einzelsubstrate zur Herstellung der notwendigen Leiterbahnen, Kontaktflächen usw., aber auch eine spätere Bestückung mit den elektrischen Bauelementen an dem Mehrfach-Substrat erfolgen kann, welches dann nach der Fertigstellung der Einzelsubstrate und/oder der Bestückung in diese Einzelsubstrate bzw. in die einzelnen Schaltkreise durch Brechen entlang der Sollbruchlinien getrennt wird. Die Metallisierungen der Einzelsubstrate können bis an die Sollbruchstellen reichen, überbrücken diese aber nicht, um das Trennen durch Brechen zu ermöglichen.

Insbesondere dann, wenn das Mehrfach-Substrat bzw. dessen Keramikschicht großflächig ist, d.h. große Abmessungen aufweist, kann während der Behandlung, d.h. beispielsweise während der Strukturierung der Metallflächen der Einzelsubstrate zur Erzielung der notwendigen Leiterbahnen Kontaktflächen usw. oder aber auch bei anderen Behandlungsverfahren selbst bei einem sorgfältigen Handling ein unerwünschtes Brechen der Keramikschicht mit Sicherheit nicht ausgeschlossen werden, insbesondere auch dann, wenn die Sollbruchlinien so ausgeführt sind, daß sie beim späteren gewünschten Zertrennen des Mehrfach-Substrates in die Einzelsubstrate tatsächlich ein Brechen der Keramikschicht nur an den Sollbruchlinien und kein unkontrolliertes Brechen sicherstellen.

Bekannt ist weiterhin (DE 39 06 690-A2) bei einem Keramik-Substrat für Leistungshalbleiter-Modulen die verwendete Keramikschicht in einzelne stumpf oder überlappend aneinander anschließende Plättchen zu unterteilen oder aber mit vorgegebenen Schlitzen oder Sollbruchlinien zu versehen, um bei hoher thermischer Belastung des Keramik-Substrates ein unerwünschtes willkürliches Brechen der Keramikschicht zu vermeiden. Die unterteilt oder mit den Sollbruchlinien versehene Keramikschicht ist dann zum Zusammenhalt der einzelnen Teile an wenigstens einer Oberflächenseite ganzflächig mit einer durchgehenden Metallisierung versehen.

Sinn und Zweck der Schlitze und Sollbruchlinien ist in diesem bekannten Fall ausschließlich ein unerwünschtes, willkürliches Brechen der Keramikschicht bei thermischer Belastung zu vermeiden. Ein Trennen dieses bekannten Keramik-Substrates an den Schlitzen oder Sollbruchlinien in Einzelsubstrate ist nicht vorgesehen und würde erfordern, die durchgehende Metallisierung an den Schlitzen oder Sollbruchlinien ebenfalls zu trennen, was einen erheblichen und insbesondere auch bei einer Trennung eines Mehrfach-Substrates in Einzelsubstrate nicht akzeptierbaren Aufwand darstellen würde.

Bekannt ist weiterhin auch, ein großflächiges Substrat für Halbleiter-Baueinheiten (DE 39 39 794-A1), welches aus einer Trägerplatte aus Kunststoff besteht, auf der voneinander beabstandet mehrere kleinere Keramikplättchen befestigt sind, die als isolierende Schicht für Leiterbahnen, Kontaktflächen und zugehörige elektrische Bauelemente dienen. Durch Verwendung einzelner, auf der Trägerplatte aus Kupfer ganzflächig befestigter kleinerer Keramikplättchen sollen Beschädigungen der Keramik bei größerer thermischer Wechsel-Belastung vermieden werden.

Bekannt ist auch ein gattungsgemäßeses Mehrfachsubstrat sowie ein Verfahren zum Herstellen von Einzel-Substraten aus Keramik (US 3 926 746), bei dem in wenigstens eine ungebrannte Keramikschicht eine Vielzahl von Öffnungen eingestanzt wird, die Sollbruchlinien zum späteren Trennen des Mehrfach-Substrates in die Einzel-Substrate bilden, und bei dem auf der Keramikschicht eine strukturierte Metallisierung im Siebdruckverfahren erzeugt wird, und zwar derart, daß Leiterbahnen und Kontaktflächen für die Einzelsubstrate, die Sollbruchlinien überbrückende Metallstege sowie ein umlaufender Metallrand erzeugt werden, die durch das Herstellungsverfahren bedingt eine geringe Dicke und damit geringe mechanische Festigkeit aufweisen. Der umlaufende Metallrand, der über die Metallstege mit den Leiterbahnen und Anschlüssen elektrisch verbunden ist, dient bei diesen bekannten Verfahren auch ausschließlich dazu, um durch die elektrische Verbindung eine möglichst gleichmäßige galvanische Oberflächenveredelung der gesamten Metallisierung zu ermöglichen, beispielsweise durch Aufbringen einer Goldschicht.

Bekannt ist weiterhin (US 4 922 326) bei sogenannten Packages oder Gehäusen für Halbleiterchips aus Keramik zusätzlich zu den wiederum in Siebdrucktechnik auf der Keramik erzeugten Leiterbahnen und Kontaktflächen auch zusätzliche Metallflächen im Bereich der Ecken zu erzeugen, die ausschließlich dazu dienen, die Gefahr der Bildung von Mikrorissen im Keramik-Material zu verringern.

Bekannt ist es auch, die zum Herstellen von Leiterbahnen, Anschlüssen usw. benötigte Metallisierung auf einer Keramik, z.B. auf einer Aluminium-Oxid-Keramik mit Hilfe des sogenannten "DCB-Verfahrens" (Direct-Copper-Bond-Technol ogy) herzustellen, und zwar unter Verwendung von die Metallisierung bildenden Kupferfolien, die an ihren Oberflächenseiten eine Schicht oder einen Überzug (Aufschmelzschicht) aus einer chemischen Verbindung aus dem Kupfer und einem reaktiven Gas, bevorzugt Sauerstoff aufweisen. Bei diesem beispielsweise in der US-PS 39 94 430 beschriebenen Verfahren bildet diese Schicht oder dieser Überzug (Aufschmelzschicht) ein Eutektikum mit einer Schmelztemperatur unter der Schmelztemperatur des Kupfers, so daß durch Auflegen der Kupfer-Folie auf die Keramik und durch Erhitzen sämtlicher Schichten diese miteinander verbunden werden können, und zwar durch Aufschmelzen des Kupfers im wesentlichen nur im Bereich der Aufschmelzschicht bzw. Oxidschicht. Die Kupferfolie besitzt eine Dicke von etwa 250 µm.

Dieses DCB-Verfahren weist dann z.B. folgende Verfahrensschritte auf:
- Oxidieren einer Kupferfolie derart, daß sich eine gleichmäßige Kupferoxidschicht ergibt;
- Auflegen des Kupferfolie auf die Keramikschicht;
- Erhitzen des Verbundes auf eine Prozeßtemperatur zwischen etwa 1065 bis 1083°C, z.B. auf ca. 1071°C;
Abkühlen auf Raumtemperatur.

Bekannt ist weiterhin auch ein sogenanntes Aktiv-Löt-Verfahren zum Verbinden von Metall mit Keramiken aus Karbiden (DE 22 13 115 C3). Bei diesem bekannte Verfahren wird zwischen den dem Metall und der Keramik ein Aktivlot verwendet, d.h. ein Lot mit einem Aktivmetall, dessen Bindungsenthalpie zur Keramik wenigstens 50% der Bindungsethalpie der betreffenden Keramik beträgt, so daß beim Erhitzen auf 800 bis 1000° C nicht nur eine Verbindung des Lotes mit der Metallisierung erreicht wird, sondern das Aktivmetall des Lotes auch Bindungsbrücken mit dem Karbit bzw. mit der Keramik bildet.

Aufgabe der Erfindung ist es, ein Mehrfach-Substrat aufzuzeigen, welches nach Abschluß der Behandlung bequem in Einzelsubstrate zertrennbar ist, und zwar entlang der auf der gemeinsamen Keramikschicht zwischen den Einzel-Substraten und den Randbereichen vorgesehenen weiteren Sollbruchstellen, wobei ein unerwünschtes Brechen der Keramikschicht während der Behandlung wirksam verhindert ist.

Zur Lösung dieser Aufgabe ist ein Mehrfach-Substrat entsprechend dem kennzeichnenden Teil des Patentanspruches 1 ausgebildet. Ein bevorzugtes Verfahren zum Herstellen des Mehrfach-Substrates ist Gegenstand des Patentanspruches 12.

Bei der Erfindung werden die zwischen den Einzel-Substraten verlaufenden ersten und zweiten Sollbruchlinien oder deren Verlängerungen jeweils durch die zusätzliche Metallflächen überbrückt, die an den wenigstens zwei Randbereichen der Keramikschicht vorgesehen sind, d.h. sich außerhalb des von den Einzel-Substraten eingenommenen Bereichs der Keramikschicht befinden und die ihrerseits durch die zusätzlichen äußeren Sollbruchlinien, die sich jeweils entlang der zusätzlichen Metallfläche erstrecken, von dem übrigen Substrat durch Abbrechen entfernbar sind, und zwar dann, wenn ein gewolltes Trennen des Mehrfach-Substrates in die Einzel-Substrate erfolgt.

Die Einzel-Substrate sind in mehreren gegeneinander versetzten Reihen an der Keramikschicht gebildet, wobei jede Reihe mehrere aneinander anschließende Einzelsubstrate aufweist. An wenigstens zwei in einem Winkel, vorzugsweise in einem rechten Winkel aneinander anschließenden Randbereichen ist jeweils eine zusätzliche Metallisierung vorgesehen. Jeder Randbereich schließt über eine äußere weitere Sollbruchlinie an benachbarte Einzel-Substrate an. Die zusätzliche äußere Metallfläche an jedem Randbereich überbrückt die quer oder senkrecht zu diesem Randbereich verlaufenden ersten und zweiten Sollbruchlinien zwischen den Einzel-Substraten oder deren gedachte Verlängerung. Die an dem ersten der wenigstens zwei Randbereiche vorgesehene zusätzliche Metallfläche überbrückt vorzugsweise weiterhin auch diejenige äußere Sollbruchlinie oder deren Verlängerung, die zwischen dem zweiten Randbereich und den angrenzenden Einzel-Substraten vorgesehen ist, während die äußere Sollbruchlinie zwischen dem ersten Randbereich und den angrenzenden Einzel-Substraten oder die gedachte Verlängerung dieser äußeren Sollbruchlinie durch keine zusätzliche Metallfläche überbrückt wird.

Durch erfindungsgemäße Ausgestaltung werden Biegekräfte, die bei der Handhabung des Mehrfach-Substrates auftreten, durch die zusätzlichen Metallflächen auf jeden Fall soweit aufgenommen, daß ein ungewolltes Brechen des Mehrfach-Substrates in die Einzel-Substrate wirksam verhindert ist. Weiterhin ist durch die vorstehend beschriebene bevorzugte Ausgestaltung ein gewünschtes Brechen des Mehrfach-Substrates in die Einzel-Substrate nur dadurch möglich, daß die Randbereiche in einer bestimmten Reihenfolge abgebrochen werden, und zwar zunächst der erste Randbereich entlang der diesen Randbereich definierenden bzw. parallel zu diesem Randbereich verlaufenden äußeren Sollbruchlinie und im Anschluß daran der zweite Randbereich an der parallel zu diesem Randbereich verlaufenden äußeren Sollbruchlinie. Erst im Anschluß daran ist das Trennen des Mehrfach-Substrates in die Einzel-Substrate durch Brechen möglich.

Das Mehrfach-Substrat läßt sich im Behandlungsverfahren ohne weiteres so handhaben, daß ein Brechen an der parallel zu dem einen Randbereich verlaufenden äußeren Sollbruchlinie nicht eintreten kann, womit dann auch ein unerwünschtes Brechen an anderen Sollbruchlinien ausgeschlossen ist.

Weiterbildungen der Erfindung sind Gegenstand der Unteransprüche.

Die Erfindung wird im Folgenden anhand der Figuren an einem Ausführungsbeispiel näher erläutert. Es zeigen:
- Fig. 1: in vereinfachter Darstellung und in Draufsicht ein Mehrfach-Substrat gemäß der Erfindung;
- Fig. 2: einen Schnitt entsprechend der Linie I - I der Figur 1;
- Fig. 3 - 5: in ähnlichen Darstellungen wie Fig. 1 weitere, mögliche Ausführungsformen des erfindungsgemäßen Mehrfach-Substrates.

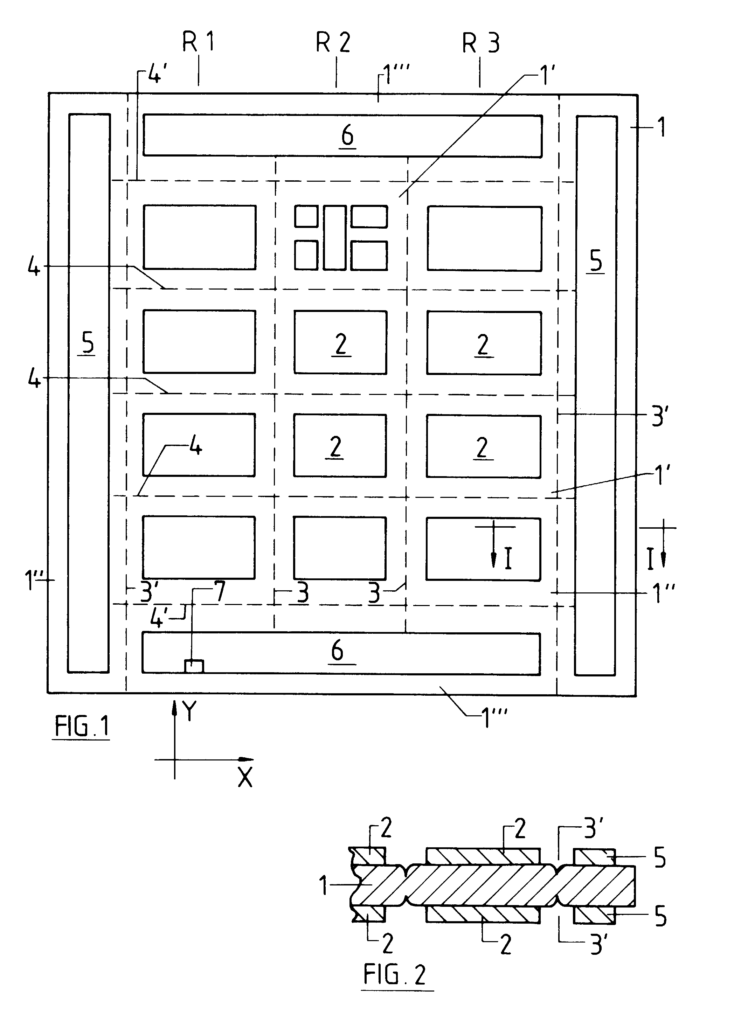

Das in den Fig. 1 und 2 dargestellte Mehrfach-Substrat besteht im wesentlichen aus einer Keramikschicht 1, die beispielsweise eine Aluminiumnitrid-Keramik oder eine Aluminiumoxid-Keramik ist und bei der dargestellten Ausführungsform an beiden Oberflächenseiten mit einer Vielzahl von Metallisierungen in Form von rechteckförmigen Metallflächen 2 versehen ist. Diese Metallflächen 2, die aus Kupfer bestehen und jeweils flächig mit der jeweiligen Oberflächenseite der Keramikschicht 1 verbunden sind, besitzen bei der dargestellten Ausführungsform jeweils gleiche Form und Größe und sind jeweils rechteckfömig ausgebildet. Jeder Metallfläche 2 an der einen Oberflächenseite der Keramikschicht 1 liegt eine Metallfläche 2 an der anderen Oberflächenseite dieser Keramikschicht unmittelbar gegenüber. Die Metallflächen 2 an einer Oberflächenseite sind strukturiert, wie dies der einfacheren Darstellung wegen in der Fig. 1 lediglich für eine der Metallflächen 2 angedeutet ist.

Es versteht sich, daß die Metallflächen auch eine von der Rechteckform abweichende Form aufweisen und/oder die Metallflächen 2 an jeder Oberflächenseite der Keramikschicht 1 oder aber an den beiden Oberflächenseiten dieser Keramikschicht unterschiedlich geformt sein können.

Die Metallflächen 2 sind an den beiden Oberflächenseiten der Keramikschicht 1 in mehreren Reihen vorgesehen, und zwar bei der dargestellten Ausführungsform in insgesamt drei Reihen R1-R3, von den jede vier Metallflächen besitzt. Die in den Reihen R1-R3 aufeinanderfolgenden Metallflächen 2 sowie auch die Metallflächen der benachbarten Reihen sind an beiden Oberflächenseiten der Keramikschicht 1 jeweils voneinander beabstandet, und zwar derart, daß die Mittellinien parallel zu den Reihen R1-R3 sowie senkrecht zu diesen zwischen benachbarten Metallfächen 2 an der einen Oberflächenseite der Keramikschicht 1 deckungsgleich mit den entsprechenden Mittellinien an der anderen Oberflächenseite dieser Keramikschicht liegen.

Entlang dieser Mittellinie ist die Keramikschicht an beiden Oberflächenseiten mit Sollbruchlinien 3 (parallel zu den Reihen R1-R3) sowie mit Sollbruchlinien 4 (senkrecht zu den Reihen R1-R3) versehen. Durch die Sollbruchlinien 3 und 4 und weitere Sollbruchlinien 3' und 4' ist die Keramikschicht 1 in eine Vielzahl von Nutzen 1' unterteilt.

Am Rand der bei der dargestellten Ausführungsform rechteckförmigen Keramikschicht 1 weist diese an einer Oberflächenseite zusätzliche Metallisierungen in Form von streifenförmigen Metallflächen 5 und 6 auf, von denen die Metallflächen 6 jeweils entlang eines parallel zu den Sollbruchlinien 4 und 4' verlaufenden Randbereiches 1''' der Keramikschicht 1 und die Metallflächen 5 an dem parallel zu den Reihen R1-R3 bzw. Sollbruchlinien 3 und 3' verlaufenden Randbereich 1'' vorgesehen sind. Zwischen diesen zusätzlichen langgestreckten Metallisierungen 5 und 6 und den benachbarten Metallflächen 2 bzw. Nutzen 1' sind an beiden Oberflächenseiten der Keramikschicht 1 die Sollbruchlinien 3' bzw. 4' vorgesehen. Es versteht sich, daß die Sollbruchlinien 3 und 4 bzw. 3' und 4' an den beiden Oberflächenseiten der Keramikschicht 1 derart vorgesehen sind, daß jeweils einer Sollbruchlinie 3 oder 4 bzw. 3' oder 4' an einer Oberflächenseite eine entsprechende Sollbruchlinie 3 oder 4 bzw. 3' oder 4' an der anderen Oberlächenseite unmittelbar gegenüber liegt.

Bei der dargestellten Ausführungsform sind die zusätzlichen Metallflächen so dimensioniert und angeordnet, daß die zwischen den Metallflächen 2 und den Metallflächen 5 vorgesehenen Sollbruchlinien 3' bis an den Rand der Keramikschicht 1 reichen, und zwar dadurch, daß die Metallflächen 5 zwar jeweils mit ihren schmäleren Seiten bzw. Enden auf einer gemeinsamen, gedachten Linie mit der außenliegenden, d.h. den Metallflächen 2 abgewandten Längsseite der Metallflächen 6 angeordnet sind, die Metallflächen 5 und 6 aber nicht unmittelbar aneinander anschließen, sondern voneinander beabstandet sind.

Die zwischen den Metallflächen 2 und den zusätzlichen Metallflächen 5 verlaufenden Sollbruchlinien 3' werden von sämtlichen Sollbruchlinien 4 und 4' geschnitten.

Mit Ausnahme der zwischen den Metallflächen 2 und den zusätzlichen Metallflächen 5 verlaufenden Sollbruchlinien 3' enden die Sollbruchlinien 3 an den zusätzlichen Metallflächen 6. In gleicher Weise enden sämtliche Sollbruchlinien 4 und 4' an den zusätzlichen Metallflächen 5.

Bei der bevorzugten Ausgestaltung dieser Ausführungsform enden die Sollbruchlinien 4 und 4' an den äußeren Sollbruchlinien 3' und die Sollbruchlinien 3 an den äußeren Sollbruchlinien 4'.

Grundsätzlich besteht die Möglichkeit, an beiden Oberflächenseiten der Keramikschicht 1 oder nur an eier Oberflächenseite die zusätzlichen Metallflächen 5 und 6 vorzusehen.

Die Metallflächen 2, 5 und 6 sind bevorzugt Flächen aus Kupfer.

Das beschriebene Mehrfach-Substrat wird beispielsweise dadurch hergestellt, daß auf beiden Oberflächenseiten der Keramikschicht 1 einer diese Oberflächenseiten vollständig oder nahezu vollständig abdeckende Metallschicht aufgebracht wird, und zwar in Form einer Metallfolie oder dünnen Metallplatte, die flächig mit der jeweiligen Oberflächenseite der Keramikschicht 1 verbunden wird, und zwar mittels des Direct-Bonding-Verfahrens, oder Aktiv-Lot-Verfahren, welche dem Fachmann aus der Literatur bekannt sind und welche bei Verwendung von Folien oder dünnen Platten aus Kupfer auch als DCB-Verfahren (Direct-Copper-Bonding-Verfahren) oder als AMB (Active-Metal-Brazing-Verfahren) bezeichnet werden.

Durch eine anschließende Vorstrukturierung der durchgehenden Metallschichten auf den beiden Oberflächenseiten der Keramikschicht 1 werden dann die einzelenen Metallflächen 2, 5 und 6 erzeugt. Diese Strukturierung kann mittels verschiedenster Verfahren erfolgen, beispielsweise durch Ätzen und/oder durch mechanische Verfahren. Nach der Strukturierung, d.h. nach der Bildung der Metallflächen 2, 5 und 6 erfolgt mit geeigneten Techniken das Einbringen der Sollbruchstellen bzw. Sollbruchlinien 3, 4, 3' und 4', beispielsweise durch Laser-Behandlung oder mechanische Verfahren, wie Ritzen usw..

Es ist auch möglich, die Sollbruchlinien 3, 4, 3' und/oder 4' vor der Metallbeschichtung aufzubringen. Durch die nachfolgende Strukturierung vorzugsweise durch Maskieren und Ätzen werden die Sollbruchlinien dann während des Ätzens freigelegt.

Weiterhin ist es auch möglich, bereits strukturierte Metallflächen mit der Keramik durch das DCB-Verfahren oder durch das AMB-Verfahren zu verbinden, wobei die Sollbruchlinien 3, 4, 3' und/oder 4' entweder vor oder nach dem Verbinden der Metallflächen erzeugt werden.

In der beschriebenen, vorstrukturierten Form wird das Mehrfach-Substrat vom Substrathersteller an den Verwender geliefert, der dann dieses Substrat als Mehrfachnutzen bei der Herstellung von elektrischen Schaltkreisen, insbesondere Leistungsschaltkreisen verarbeitet, beispielsweise maschinell mit den erforderlichen Bauteilen bestückt. Erst nach diesen Bestücken und gegebenenfalls nach einer Prüfung der hergestellten Schaltkreise wird der Mehrfachnutzen in die einzelnen Schaltkreise zertrennt, und zwar durch Brechen der Keramikschicht 1 entlang der Sollbruchlinien 3, 4, 3' und 4'. Durch die zusätzlichen Metallflächen 5 und 6 ist ein unerwünschtes Brechen des Mehrfach-Substrates bzw. Mehrfachnutzens im Verfahren wirksam verhindert. Dadurch, daß die zwischen den Metallflächen 2 und den zusätzlichen Metallflächen 5 verlaufenden Sollbruchlinien 3' bis an den Rand der Keramikschicht 1 reichen ist ein Trennen des Mehrfachnutzens in-verschiedenen Einzelsubstrate bzw. Schaltkreise möglich, ohne daß ein Durchtrennen einer der zusätzlichen Metallflächen 5 und 6 notwendig ist, d.h. beim Trennen des Mehrfachnutzens in Einzelnutzen oder Einzelsubstrate bzw. in die einzelnen Schaltkreise erfolgt das Brechen zunächst an den äußeren, den Metallflächen 5 benachbarten Sollbruchlinien 3' und anschließend an den äußeren, den Metallflächen 6 benachbarten Sollbruchlinien 4', womit dann der diese zusätzlichen Metallflächen 5 und 6 aufweisende Rand entfert ist und der verbleibende Teil des Mehrfach-Substrates dann ohne Probleme an den Sollbruchlinien 3 und 4 durch Brechen getrennt werden kann.

Obwohl die Sollbruchlinien 3' bis an den Rand der Keramikschicht 1 reichen, besteht nicht die Gefahr, daß das Mehrfach-Substrat in unerwünschter Weise während des Verfahrens entlang dieser äußeren Sollbruchlinien 3' bricht, da insbesondere dann, wenn das Mehrfach-Substrat im Verfahren beim Handling stets an zwei gegenüberliegenden Seitenrändern erfaßt wird, keine Biegekräfte auftreten, die ein Brechen des Substrates an den außenliegenden Sollbruchlinien 3' bewirken könnten. Grundsätzlich ist es aber auch möglich, das Handling des Mehrfach-Substrates im Verfahren derart vorzusehen, daß dieses Substrat stets nur an den die Metallfächen 6 aufweisenden Randbereichen 1''' gefaßt wird.

Die Metallflächen 5 und 6 können auch mit einer eine Kodierung bildende Stukturierung, beispielsweise mit eine Kodierung bildenden Ausnehmungen 7 versehen sein. Diese Automaten lesbare Kodierung kann dann Informationen über die Art der hergzustellenden Schaltkreise enthalten und damit zur Steuerung und/oder Überwachung des Fertigungsprozesses dienen, oder aber dazu verwendet werden, um eine vorgegebene Orientierung des Mehrfach-Substrates in einer Verarbeitungseinrichtung sicher zu stellen.

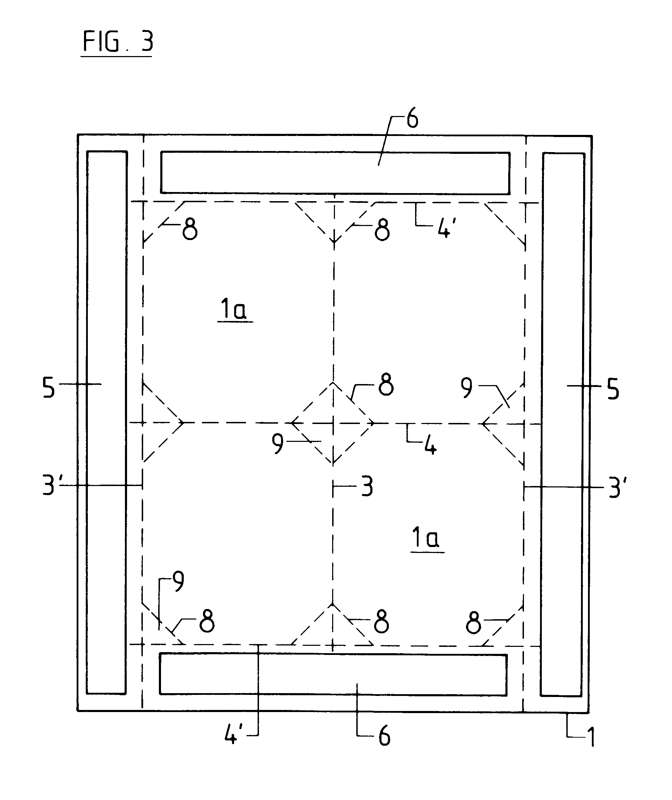

Die Fig. 3 zeigt als weitere mögliche Ausführungsform der Erfindung ein Mehrfach-Substrat, welches wiederum aus der Keramikschicht, aus den in dieser Figur nicht dargestellten, auf der Keramikschicht 1 vorgesehenen Metallflächen sowie aus den zusätzlichen Metallflächen 5 und 6 besteht. Die Keramikschicht 1 ist wiederum mit den rechtwinklig zueinander verlaufenden Sollbruchlinien 3, 4, 3' und 4' versehen. Weiterhin sind in die Keramikschicht 1 bei diesem Mehrfach-Substrat kurze geradlinige Sollbruchlinien 8 vorgesehen, von denen jede mit einem Ende an einer Sollbruchlinie 3 oder 3' und mit ihrem anderen Ende an einer Sollbruchlinie 4 bzw. 4' endet und mit diesen Sollbruchlinien einen Winkel kleiner als 90^{o} einschließt, der sich zu dem Schnittpunkt der zugehörigen Sollbruchlinien 3, 3', 4 oder 4' hin öffnet, derart, daß der jeweilige, von den Sollbruchlinien definierte Nutzen 1a die Form eines Quadrates oder Rechteckes mit abgeschrägten Ecken aufweist.

Das Trennen des Mehrfach-Substrates der Fig. 3 in die Einzelnutzen 1a erfolgt in der gleichen Weise, wie dies vorstehend für das Substrat nach Fig. 1 beschrieben wurde, lediglich mit dem Unterschied, daß am Schluß noch das Brechen entlang der Sollbruchlinien 8 erfolgt. Die dabei anfallenden Reste 9 werden weggeworfen.

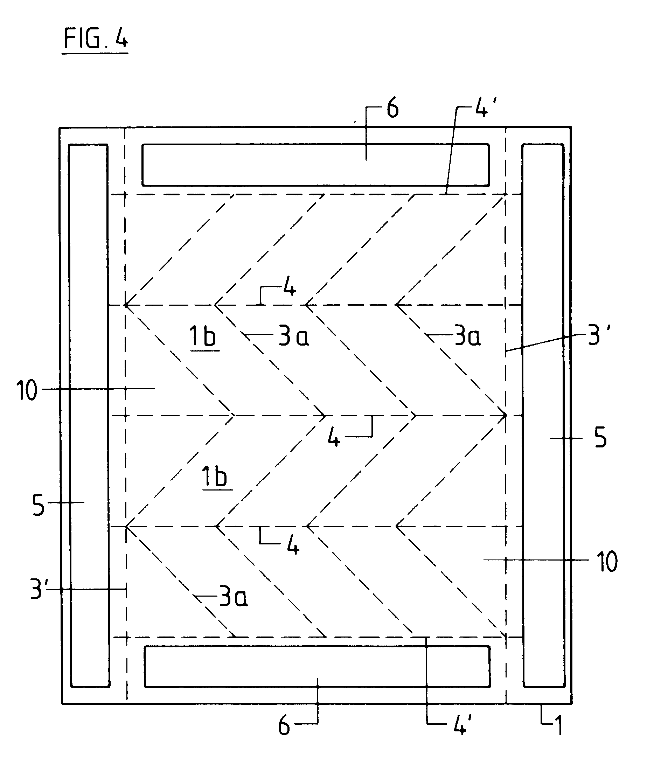

Fig. 4 zeigt ein Mehrfach-Substrat, bei dem lediglich die Sollbruchlinien 3', 4 und 4' geradlinig verlaufen, anstelle der Sollbruchlinien 3 zick-zack-förmige Sollbruchlinien 3a vorgesehen sind, deren Wendepunkt jeweils auf einer Sollbruchlinie 4 liegt, so daß diese Sollbruchlinien 3a in Verbindung mit den Sollbruchlinien 4 parallelogrammförmige Nutzen 1b definieren. Ebenso wie das Substrat der Fig. 3 weist auch das Mehrfach-Substrat der Fig. 4 wiederum die zusätzlichen Metallflächen 5 und 6 auf. Das Zertrennen des Mehrfach-Substrates in die Einzelnutzen 1b erfolgt wiederum durch Brechen in der Weise, wie dies für das Mehrfach-Substrat der Fig. 1 beschrieben wurde, wobei allerdings nach dem Abtrennen der Randbereiche 1'' und 1''' zunächst ein Brechen an den Sollbruchlinien 4 erfolgt, so daß als Zwischenprodukt mehrere Streifen erhalten werden, die dann an den Sollbruchlinien 3a gebrochen werden können. Die zwischen den äußeren Sollbruchlinien 3' bzw. zwischen den Randbereichen 1'' und benachbarten Nutzen 1b anfallenden dreieckförmigen Reste 10 sind Abfall und werden weggeworfen.

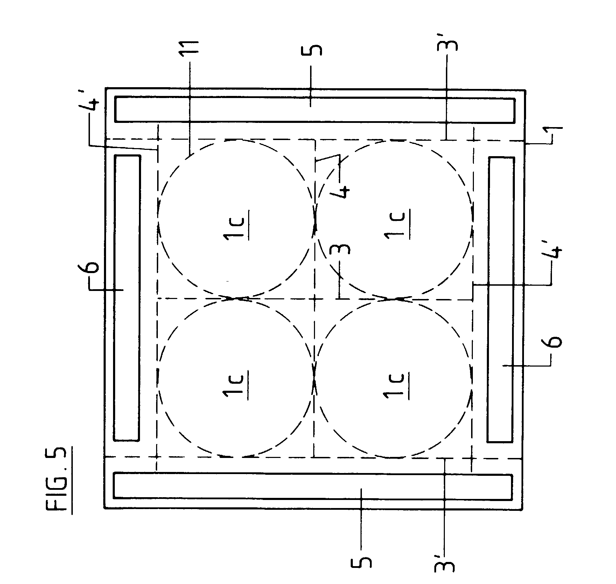

Die Fig. 5 zeigt als weitere mögliche Ausführungsform schließlich ein Mehrfach-Substrat, welches dem Mehrfach-Substrat der Fig. 3 sehr ähnlich ist, sich von diesem aber dadurch unterscheidet, daß anstelle der kurzen, geradlinigen Sollbruchlinien 8 kreisbogenförmige Sollbruchlinien 11 vorgesehen sind, und zwar zusätzlich zu den Sollbruchlinien 3, 4, 3' und 4'. Bei der in der Fig. 5 dargestellten Ausführungsform ergänzen sich jeweils vier Sollbruchlinien 11 zu einem Kreis, der von den Sollbruchlinien 3' und 3 sowie von zwei Sollbruchlinien 4 oder den Sollbruchlinien 4' umschlossen ist. Jeder Einzelnutzen ist bei dieser Ausführungsform in etwa kreisscheibenförmig ausgebildet.

Die Erfindung wurde voranstehend an Ausführungsbeispielen beschrieben. Es versteht sich, daß zahlreiche Änderungen sowie Abwandlungen möglich sind. So ist es beispielsweise möglich, die Sollbruchlinien 3, 3a, 4, 3' und/oder 4' nur an einer Oberflächenseite der Keramikschicht 1 vorzusehen. Weiterhin ist es auch möglich, die zusätzlichen Metallflächen 5 und 6 an beiden Oberflächenseiten der Keramikschicht 1 vorzusehen.

### Bezugszeichenliste

- 1: Keramikschicht
- 1', 1a,: Nutzen
- 1b, 1c: Nutzen
- 1'',1''': Randbereich
- 2: Metallfläche
- 3, 4: Sollbruchlinie
- 3', 4': Sollbruchlinie
- 5, 6: zusätzliche Metallfläche
- 7: Ausnehmung
- 8: Sollbruchlinie
- 9, 10: Rest
- 11: Sollbruchlinie
- R1 - R3: Reihen

## Patentansprüche

1. Mehrfach-Substrat mit einer Keramikschicht (1), die vier aneinander anschließende Randbereiche (1", 1"') und mehrere über die Keramikschicht einstückig miteinander verbundene Einzelsubstrate (1', 1a, 1b, 1c) bildet, die aneinander anschließend in wenigstens zwei einander benachbarten Reihen (R1 - R3) auf der Keramikschicht vorgesehen sind, wobei jede Reihe jeweils wenigstens zwei in Richtung der Reihe aneinander anschließende Einzelsubstrate (1', 1a, 1b, 1c) aufweist, und die jeweils an wenigstens einer Oberflächenseite der Keramikschicht (1) mit wenigstens einer Metallisierung (2) versehen sind, wobei die Einzelsubstrate (1', 1a, 1b, 1c) über in der Keramikschicht vorgesehene innere Sollbruchlinien (3, 3a, 4) aneinander anschließen, von denen erste innere Sollbruchlinien (3, 3a) zwischen den Einzelsubstraten (1', 1a, 1b, 1c) benachbarter Reihen (R1 - R3) und zweite innere Sollbruchlinien (4) zwischen den Einzelsubstraten (1', 1a, 1b, 1c) in den Reihen (R1 - R3) verlaufen, wobei zusätzlich zu den ersten und zweiten inneren Sollbruchlinien (3, 3a, 4) wenigstens zwei weitere äußere Sollbruchlinien (3', 4') in der Keramikschicht (1) vorgesehen sind, von denen wenigstens eine erste (3') entlang eines außerhalb der Einzelsubstrate liegenden ersten Randbereichs (1") und wenigstens eine zweite (4') entlang eines außerhalb der Einzelsubstrate liegenden zweiten Randbereichs (1"') verläuft, wobei an diesen Randbereichen (1", 1"') an wenigstens einer Oberflächenseite der Keramikschicht jeweils wenigstens eine zusätzliche äußere Metallfläche (5, 6) vorgesehen ist, die die ersten oder zweiten inneren Sollbruchlinien (3, 3a, 4) oder deren Verlängerungen überbrückt, **dadurch gekennzeichnet,** daß die Metallisierungen (2) der Einzelsubstrate (1') sowie die zusätzlichen Metallflächen (5, 6) jeweils von einer Metallfolie gebildet sind, die durch das Direct-Bonding- oder Activ-Lot-Verfahren flächig mit der Keramikschicht (1) verbunden ist, und daß wenigstens eine erste äußeren Sollbruchlinie (3') oder deren Verlängerung von keiner zusätzlichen äußeren Metallfläche (5, 6) überbrückt ist.

2. Mehrfach-Substrat nach Anspruch 1, dadurch gekennzeichnet, daß der erste und zweite Randbereich (1", 1"') aneinander anschließen und einen Winkel miteinander bilden, daß die zusätzliche äußere Metallfläche (6) an dem zweiten Randbereich (1"') die ersten inneren Sollbruchlinien (3, 3a) oder deren Verlängerungen überbrückt, und daß die zusätzliche äußere Metallfläche (5) an dem ersten Randbereich (1") die zweiten inneren Sollbruchlinien (4) oder deren Verlängerungen sowie auch die wenigstens eine zweite äußere Sollbruchlinie (4') oder deren Verlängerung überbrückt.

3. Mehrfach-Substrat nach nach Anspruch 2, dadurch gekennzeichnet, daß die Randbereiche (1", 1"') rechtwinklig aneinander anschließen.

4. Mehrfach-Substrat nach Anspruch 3, dadurch gekennzeichnet, daß bei den vier Randbereichen (1", 1"') mit zusätzlichen äußeren Metallflächen (5, 6) jeweils zwei einander gegenüberliegende Randbereiche erste Randbereiche (1") und zwei einander gegenüberliegende Randbereiche zweite Randbereiche (1"') bilden, daß die zusätzlichen äußeren Metallflächen (5) an den ersten Randbereichen (1") auch die zweiten äußeren Sollbruchlinien (4') oder deren Verlängerungen überbrücken, und daß jede erste äußere Sollbruchlinie (3') oder deren Verlängerung von den zusätzlichen äußeren Metallfächen (6) der zweiten Randbereiche (1"') nicht überbrückt ist.

5. Mehrfach-Substrat nach einem der vorhergehenden Ansprüche, dadurch gekennzeichnet, daß die ersten und zweiten inneren Sollbruchlinien (3, 3a, 4) bis an die weiteren äußeren Sollbruchlinien (3', 4') reichen oder diese schneiden.

6. Mehrfach-Substrat nach einem der vorhergehenden Ansprüche, dadurch gekennzeichnet, daß die ersten und zweiten inneren Sollbruchlinien (3, 3a, 4) einen Winkel von 90° miteinander einschließen.

7. Mehrfach-Substrat nach einem der vorhergehenden Ansprüche, dadurch gekennzeichnet, daß die ersten und zweiten inneren Sollbruchlinien (3, 3a, 4) einen Winkel kleiner als 90° miteinander einschließen.

8. Mehrfach-Substrat nach einem der vorhergehenden Ansprüche, dadurch gekennzeichnet, daß die Keramikschicht (1) zur Bildung der Sollbruchlinien (3, 4, 3', 4') an wenigstens eine Oberflächenseite geritzt oder mit nutenförmigen Vertiefungen versehen ist.

9. Mehrfach-Substrat nach einem der vorhergehenden Ansprüche, dadurch gekennzeichnet, daß die Metallisierungen Metallflächen (2) sind, die mit ihren Randlinien parallel zu den Sollbruchlinien (3, 4, 3', 4') verlaufen.

10. Mehrfach-Substrat nach einem der vorhergehenden Ansprüche, dadurch gekennzeichnet, daß an den Einzelsubstraten (1') an beiden Oberflächenseiten der Keramikschicht (1) jeweils wenigstens eine Metallisierung (2) vorgesehen ist.

11. Mehrfach-Substrat nach einem der vorhergehenden Ansprüche, dadurch gekennzeichnet, daß die zusätzlichen Metallflächen (5, 6) an den Randbereichen (1", 1"') jeweils an beiden Oberflächenseiten der Keramikschicht (1) vorgesehen sind.

12. Verfahren zum Herstellen eines Mehrfach-Substrates nach einem der Ansprüche 1 bis 11, dadurch gekennzeichnet, daß eine Keramikschicht (1) mit vier aneinander anschließenden Randbereichen (1", 1"') an wenigstens einer Oberflächenseite mit einer Metallschicht versehen wird, und zwar durch flächiges Verbinden einer Metallfolie mit der Keramikschicht mittels des Direct-Bonding- oder Activ-Lot-Verfahrens, und daß dann in einem Strukturierungsprozeß die Keramikschicht mit der wenigstens einen Metallisierung derart strukturiert wird, daß mehrere über die Keramik einstückig miteinander verbundene Einzelsubstrate (1', 1a, 1b, 1c) gebildet sind, die aneinander anschließend in wenigstens zwei einander benachbarten Reihen (R1 - R3) auf der Keramikschicht vorgesehen sind, wobei jede Reihe jeweils wenigstens zwei in Richtung der Reihe aneinander anschließende Einzelsubstrate (1', 1a, 1b, 1c) aufweist, und die jeweils an wenigstens einer Oberflächenseite der Keramikschicht (1) mit wenigstens einer Metallisierung (2) versehen sind, wobei die Einzelsubstrate (1', 1a, 1b, 1c) über in der Keramikschicht vorgesehene inneren Sollbruchlinien (3, 3a, 4) aneinander anschließen, von denen erste innere Sollbruchlinien (3, 3a) zwischen den Einzelsubstraten (1', 1a, 1b, 1c) benachbarter Reihen (R1 - R3) und zweite innere Sollbruchlinien (4) zwischen den Einzelsubstraten (1', 1a, 1b, 1c) in den Reihen (R1 - R3) verlaufen, wobei zusätzlich zu den ersten und zweiten inneren Sollbruchlinien (3, 3a, 4) wenigstens zwei weitere äußere Sollbruchlinien (3', 4') in der Keramikschicht (1) vorgesehen sind, von denen wenigstens eine erste (3') entlang eines außerhalb der Einzelsubstrate liegenden ersten Randbereichs (1") und wenigstens eine zweite (4') entlang eines außerhalb der Einzelsubstrate liegenden zweiten Randbereichs (1"') verläuft, wobei an wenigstens einer Oberflächenseite der Keramikschicht wenigstens an diesen zwei aneinander anschließenden und einen Winkel miteinander einschließenden Randbereichen (1", 1"') jeweils wenigstens eine zusätzliche äußere Metallfläche (5, 6) vorgesehen ist, wobei die zusätzliche äußere Metallfläche (6) an dem zweiten Randbereich (1"') die ersten inneren Sollbruchlinien (3, 3a) oder deren Verlängerungen überbrückt und die zusätzliche äußere Metallfläche (5) an dem ersten Randbereich (1") die zweiten inneren Sollbruchlinien (4) oder deren Verlängerungen sowie die wenigstens eine zweite äußere Sollbruchlinie (4') oder deren Verlängerung überbrückt, und daß die Strukturierung weiterhin so erfolgt, daß zumindest die wenigstens eine erste weitere äußere Sollbruchlinie von keiner der zusätzlichen äußeren Metallflächen (5, 6) überbrückt ist.

13. Verfahren nach Anspruch 12, dadurch gekennzeichnet, daß vier rechtwinklig aneinander anschließende Randbereiche (1", 1"') mit zusätzlichen äußeren Metallflächen (5, 6) derart gebildet werden, daß jeweils zwei einander gegenüberliegende Randbereiche erste Randbereiche (1") und zwei einander gegenüberliegende Randbereiche zweite Randbereiche (1"') bilden, die zusätzlichen äußeren Metallflächen (5) an den ersten Randbereichen (1") auch die zweiten äußeren Sollbruchlinien (4') oder deren Verlängerungen überbrücken und jede erste äußere Sollbruchlinie (3') oder deren Verlängerung von den zusätzlichen äußeren Metallfächen (6) der zweiten Randbereiche (1"') nicht überbrückt sind.

14. Verfahren nach Anspruch 12 oder 13, dadurch gekennzeichnet, daß nach Abschluß der Strukturierung die Sollbruchlinien (3, 3a, 4, 3', 4') erzeugt werden, und zwar durch eine mechanische Behandlung oder durch eine Laser-Behandlung.

15. Verfahren nach Anspruch 12 - 14, dadurch gekennzeichnet, daß vor der Strukturierung die Sollbruchlinien (3, 3a, 4, 3', 4') erzeugt werden, und zwar durch eine mechanische Behandlung oder durch eine Laser-Behandlung.

16. Verfahren nach einem der Ansprüche 12 - 15, dadurch gekennzeichnet, daß die Strukturierung durch Ätztechnik und/oder durch mechanische Behandlung erfolgt.

## Claims

1. Multiple substrate with a ceramic layer (1), which forms four edge areas (1", 1"') adjoining one another and several individual substrates (1', 1a, 1b, 1c) connected in one piece with one another, which are provided - adjoining one another - in at least two rows (R1 - R3) adjacent to one another on the ceramic layer, with each row in each case having at least two individual substrates (1', 1a, 1b, 1c) adjoining one another in the direction of the row, and which in each case are equipped on at least one surface of the ceramic layer (1) with at least one metallization (2), with the individual substrates (1', 1a, 1b, 1c) joining on to one another via inner break-off lines (3, 3a, 4) provided in the ceramic layer, of which the first inner break-off lines (3, 3a) run between the individual substrates of (1', 1a, 1b, 1c) of neighbouring rows (R1 - R3), and the second inner break-off lines (4) run between the individual substrates (1', 1a, 1b, 1c) in the rows (R1 - R3), with - in addition to the first and second inner break-off lines (3, 3a, 4) - at least two further outer break-off lines (3', 4') being provided in the ceramic layer (1), of which at least one first such line (3') runs along a first edge area (1") lying outside the individual substrates, and at least one second line (4') runs along a second edge area (1"') lying outside the individual substrates, with at least one additional outer metal surface (5, 6) being provided in each case at these edge areas (1", 1"') on at least one surface of the ceramic layer, this [metal surface] bridging the first or second inner break-off lines (3, 3a, 4) or their extensions,
**characterized in that**
the metallizations (2) of the individual substrates (1') as well as the additional metal surfaces (5, 6) are formed in each case by a metal foil which is connected, areally, with the ceramic layer (1) by means of the direct bonding or active soldering method, and that at least one first outer break-off line (3') or its extension is not bridged by any additional outer metal surface (5, 6).

2. Multiple substrate in accordance with claim 1, characterized in that the first and second edge area (1", 1"') join on to one another and form an angle with one another; that the additional outer metal surface (6) on the second edge area (1"') bridges the first inner break-off lines (3, 3a) or their extensions; and that the additional outer metal surface (5) on the first edge area (1") bridges the second inner break-off lines (4) or their extensions, as well as the second outer break-off line (4') - of which there is at least one - or its extension.

3. Multiple substrate in accordance with claim 2, characterized in that the edge areas (1", 1"') adjoin one another at right angles.

4. Multiple substrate in accordance with claim 3, characterized in that iii the case of the four edge areas (1", 1"') with additional outer metal surfaces (5, 6), in each case two edge areas lying opposite one another form first edge areas (1") and two edge areas lying opposite one another form second edge areas (1"'); that the additional outer metal surfaces (5) on the first edge areas (1") also bridge the second outer break-off lines (4') or their extensions; and that each first outer break-off line (3') or its extension is not bridged by the additional outer metal surfaces (6) of the second edge areas (1"').

5. Multiple substrate in accordance with one of the preceding claims, characterized in that the first and second inner break-off lines (3, 3a, 4) extend as far as the further outer break-off lines (3', 4'), or intersect these.

6. Multiple substrate in accordance with one of the preceding claims, characterized in that the first and second inner break-off lines (3, 3a, 4) form an angle of 90° with one another.

7. Multiple substrate in accordance with one of the preceding claims, characterized in that the first and second inner break-offlines (3, 3a, 4) form an angle of less than 90° with one another.

8. Multiple substrate in accordance with one of the preceding claims, characterized in that in order to form the break-off lines (3, 4, 3', 4'), the ceramic layer (1) is scored or equipped with groove-like indentations on at least one surface face.

9. Multiple substrate in accordance with one of the preceding claims, characterized in that the metallizations are metal surfaces (2), the edge lines of which run parallel to the break-offlines (3, 4, 3', 4').

10. Multiple substrate in accordance with one of the preceding claims, characterized in that the individual substrates (1') are provided with at least one metallization (2) on each of the two surface faces of the ceramic layer (1).

11. Multiple substrate in accordance with one of the preceding claims, characterized in that the additional metal surfaces (5, 6) on the edge areas (1", 1"') are provided in each case on both surface faces of the ceramic layer (1).

12. Method for producing a multiple substrate in accordance with one of the claims 1 to 11, characterized in that a ceramic layer (1) with four edge areas (1", 1"') adjoining one another is equipped on at least one surface face with a metal layer, namely through areal bonding of a metal foil with the ceramic layer by means of the direct bonding or active soldering method; and that in a structuring process the ceramic layer with the metallization - of which there is at least one - is then structured in such a way that several individual substrates (1', 1a, 1b, 1c) are formed, connected in one piece with one another through the ceramic, and which are provided - adjoining one another - in at least two rows (R1 - R3) adjacent to one another on the ceramic layer, with each row in each case having at least two individual substrates (1', 1a, 1b, 1c) adjoining one another in the direction of the row, and which in each case are equipped on at least one surface face of the ceramic layer (1) with at least one metallization (2), with the individual substrates (1', 1a, 1b, 1c) joining on to one another via inner break-off lines (3, 3a, 4) provided in the ceramic layer, of which the first inner break-off lines (3, 3a) run between the individual substrates (1', 1a, 1b, 1c) of neighbouring rows (R1 - R3), and the second inner break-off lines (4) run between the individual substrates (1', 1a, 1b, 1c) in the rows (R1 - R3), with - in addition to the first and second inner break-off lines (3, 3a, 4) - at least two further outer break-off lines (3', 4') being provided in the ceramic layer (1), of which at least one first such line (3') runs along a first edge area (1") lying outside the individual substrates, and at least one second line (4') runs along a second edge area (1"') lying outside the individual substrates, whereby on at least one surface side of the ceramic layer, in each case at least one additional outer metal surface (5, 6) is provided at least on these two edge areas (1", 1"') which adjoin one another and form an angle with one another, with the additional outer metal surface (6) on the second edge area (1"') bridging the first inner break-off lines (3, 3a) or their extensions, and the additional outer metal surface (5) on the first edge area (1") bridging the second inner break-off lines (4) or their extensions as well as the second outer break-off line (4') - of which there is at least one - or its extension, and that for the rest the structuring takes place in such a way that at least the first further outer break-off line, of which there is at least one, is not bridged by any of the additional outer metal surfaces (5, 6).

13. Method in accordance with claim 12, characterized in that four edge areas (1", 1"'), adjoining one another at right angles and with additional outer metal surfaces (5, 6), are formed in such a way that in each case two edge areas lying opposite one another form first edge areas (1") and two edge areas lying opposite one another form second edge areas (1"'); and that the additional outer metal surfaces (5) on the first edge areas (1") also bridge the second outer break-off lines (4') or their extensions; and each first outer break-off line (3') or its extension is not bridged by the additional outer metal surfaces (6) of the second edge areas (1"').

14. Method in accordance with claim 12 or 13, characterized in that after completion of the structuring, the break-off lines (3, 3a, 4, 3', 4') are created, namely by means of mechanical treatment or laser treatment.

15. Method in accordance with claim 12 - 14, characterized in that before the structuring, the break-off lines (3, 3a, 4, 3', 4') are created, namely by means of mechanical treatment or laser treatment.

16. Method in accordance with one of the claims 12 - 15, characterized in that the structuring takes place by means of etching technology and/or mechanical treatment.

## Revendications

1. Substrat subdivisible comprenant une couche céramique (1) qui forme quatre zones marginales (1'', 1"') se raccordant les unes aux autres et plusieurs substrats individuels (1', la, 1b, 1c) reliés les uns aux autres d'un seul tenant par l'intermédiaire de la couche céramique, lesquels sont prévus adjacents les uns aux autres en au moins deux rangées voisines (R1 - R3) sur la couche céramique, chaque rangée présentant au moins deux substrats individuels (1', la, 1b, 1c) adjacents dans le sens de la rangée, et qui sont pourvus respectivement sur au moins une face de la couche céramique (1) d'au moins une couche de métallisation (2), les substrats individuels (1', 1a, 1b, 1c) étant reliés les uns aux autres par des lignes de rupture (3, 3a, 4) intérieures prévues dans la couche céramique, les premières lignes de rupture intérieures (3, 3a) s'étendant entre les substrats individuels (1', la, 1b, 1c) de rangées voisines (R1 - R3) et les deuxièmes lignes de rupture intérieures (4) s'étendant entre les substrats individuels (1', 1a, 1b, 1c) dans les rangées (R1 - R3), sachant qu'en plus des première et deuxième lignes de rupture intérieures (3, 3a, 4) au moins deux autres lignes de rupture extérieures (3', 4') sont prévues dans la couche céramique (1), dont au moins une première (3') s'étend le long d'une première zone marginale (1") située à l'extérieur des substrats individuels et au moins une deuxième (4') s'étend le long d'une deuxième zone marginale (1"') située à l'extérieur des substrats individuels, dans ces zones marginales (1'', 1"') étant respectivement prévue sur au moins une face de la couche céramique au moins une aire métallique extérieure supplémentaire (5, 6), qui recouvre les première ou deuxième lignes de rupture intérieures (3, 3a, 4) ou leurs prolongements, caractérisé en ce que les couches de métallisation (2) des substrats individuels (1') ainsi que les aires métalliques supplémentaires (5, 6) sont formées respectivement d'une feuille de métal qui est reliée à plat à la couche céramique (1) par le procédé de liaison directe ou de soudure active et en ce qu'au moins une première ligne de rupture extérieure (3') ou son prolongement n'est pas recouvert d'une aire métallique extérieure supplémentaire (5, 6).

2. Substrat subdivisible suivant la revendication 1, caractérisé en ce que la première et la deuxième zones marginales (1'', 1''') se raccordent l'une à l'autre et forment entre elles un angle, en ce que l'aire métallique extérieure supplémentaire (6) au niveau de la deuxième zone marginale (1"') recouvre les premières lignes de rupture intérieures (3, 3') ou leurs prolongements, et en ce que l'aire métallique extérieure supplémentaire (5) au niveau de la première zone marginale (1") recouvre les deuxièmes lignes de rupture intérieures (4) ou leurs prolongements ainsi que la au moins une deuxième ligne de rupture extérieure (4') ou son prolongement.

3. Substrat subdivisible suivant la revendication 2, caractérisé en ce que les zones marginales (1'', 1"') se raccordent perpendiculairement les unes aux autres.

4. Substrat subdivisible suivant la revendication 3, caractérisé en ce que dans les quatre zones marginales (1'', 1''') recouvertes d'aires métalliques extérieures supplémentaires (5, 6) deux zones marginales opposées forment respectivement des premières zones marginales (1'') et deux zones marginales opposées forment respectivement des deuxièmes zones marginales (1'''), en ce que les aires métalliques extérieures supplémentaires (5) recouvrant les premières zones marginales (1") recouvrent également les deuxièmes lignes de rupture extérieures (4') ou leurs prolongements, et en ce que chaque première ligne de rupture extérieure (3') ou ses prolongements n'est pas recouverte par les aires métalliques extérieures supplémentaires (6) des deuxièmes zones marginales (1''').

5. Substrat subdivisible suivant l'une quelconque des revendications précédentes, caractérisé en ce que les premières et deuxièmes lignes de rupture intérieures (3, 3a, 4) s'étendent jusqu'aux lignes de rupture extérieures supplémentaires (3', 4') ou les coupent.

6. Substrat subdivisible suivant l'une quelconque des revendications précédentes, caractérisé en ce que les premières et deuxièmes lignes de rupture intérieures (3, 3a, 4) forment ensemble un angle de 90°.

7. Substrat subdivisible suivant l'une quelconque des revendications précédentes, caractérisé en ce que les premières et deuxièmes lignes de rupture (3, 3a, 4) forment ensemble un angle inférieur à 90°.

8. Substrat subdivisible suivant l'une quelconque des revendications précédentes, caractérisé en ce que la couche céramique (1) est entaillée ou pourvue d'encoches en forme de rainures sur au moins une face pour la formation des lignes de rupture (3, 4, 3', 4').

9. Substrat subdivisible suivant l'une quelconque des revendications précédentes, caractérisé en ce que les couches de métallisation sont des aires métalliques (2) qui s'étendent par leurs lignes marginales parallèlement aux lignes de rupture (3, 4, 3', 4').

10. Substrat subdivisible suivant l'une quelconque des revendications précédentes, caractérisé en ce que sur les substrats individuels (1') au moins une couche de métallisation (2) est prévue respectivement sur les deux faces de la couche céramique (1).

11. Substrat subdivisible suivant l'une quelconque des revendications précédentes, caractérisé en ce que les aires métalliques supplémentaires (5, 6) sont prévues sur les zones marginales (1'', 1''') respectivement sur les deux faces de la couche céramique (1).

12. Procédé de fabrication d'un substrat subdivisible suivant l'une quelconque des revendications 1 à 11, caractérisé en ce qu'une couche céramique (1) comprenant quatre zones marginales (1'', 1"') se raccordant les unes aux autres sont pourvues sur au moins une face d'une couche de métallisation, et ce par liaison à plat d'une feuille de métal à la couche céramique au moyen du procédé de liaison directe ou de soudure active, et en ce qu'au cours d'un processus de structuration la couche céramique recouverte par au moins une couche de métallisation est structurée de manière telle que plusieurs substrats individuels (1', 1a, 1b, 1c) reliés les uns aux autres d'un seul tenant par l'intermédiaire de la couche céramique sont formés, lesquels sont prévus adjacents les uns aux autres en au moins deux rangées voisines (R1 - R3) sur la couche céramique, chaque rangée présentant au moins deux substrats individuels (1', 1a, 1b, 1c) adjacents dans le sens de la rangée, et sont pourvus respectivement sur au moins une face de la couche céramique (1) d'au moins une couche de métallisation (2), les substrats individuels (1', 1a, 1b, 1c) étant reliés les uns aux autres par des lignes de rupture (3, 3a, 4) intérieures prévues dans la couche céramique, les premières lignes de rupture intérieures (3, 3a) s'étendant entre les substrats individuels (1', 1a, 1b, 1c) de rangées voisines (R1 - R3) et les deuxièmes lignes de rupture intérieures (4) s'étendant entre les substrats individuels (1', 1a, 1b, 1c) dans les rangées (R1 - R3), sachant qu'en plus des première et deuxième lignes de rupture intérieures (3, 3a, 4) au moins deux autres lignes de rupture extérieures (3', 4') sont prévues dans la couche céramique (1), dont au moins une première (3') s'étend le long d'une première zone marginale (1'') située à l'extérieur des substrats individuels et au moins une deuxième (4') s'étend le long d'une deuxième zone marginale (1"') située à l'extérieur des substrats individuels, dans ces deux zones marginales (1'', 1"') se raccordant l'une à l'autre et formant un angle entre elles étant respectivement prévue sur au moins une face de la couche céramique au moins une aire métallique extérieure supplémentaire (5, 6), sachant que l'aire métallique extérieure supplémentaire (6) recouvre dans la deuxième zone marginale (1"') les premières lignes de rupture intérieures (3, 3a) ou leurs prolongements et que l'aire métallique extérieure supplémentaire (5) recouvre dans la première zone marginale (1") les deuxièmes lignes de rupture intérieures (4) ou leurs prolongements ainsi que la au moins une deuxième ligne de rupture extérieure (4') ou son prolongement, la structuration se passant en outre de telle sorte que au moins la au moins une première ligne de rupture extérieure supplémentaire ne soit recouverte par aucune des aires métalliques extérieures supplémentaires (5, 6).

13. Procédé suivant la revendication 12, caractérisé en ce que quatre zones marginales (1'', 1"') se raccordant les unes aux autres perpendiculairement et recouvertes d'aires métalliques extérieures supplémentaires (5, 6) sont formées de telle sorte que deux zones marginales opposées forment respectivement des premières zones marginales (1'') et deux zones marginales opposées forment respectivement des deuxièmes zones marginales (1"') , les aires métalliques extérieures supplémentaires (5) qui recouvrent les premières zones marginales (1'') recouvrant également les deuxièmes lignes de rupture extérieures (4') ou leurs prolongements, chaque première ligne de rupture extérieure (3') ou ses prolongements n'étant pas recouverte par les aires métalliques extérieures supplémentaires (6) des deuxièmes zones marginales (1"').

14. Procédé suivant la revendication 12 ou 13, caractérisé en ce que, après la structuration, les lignes de rupture (3, 3a, 4, 3', 4') sont formées et ce par un traitement mécanique ou par un traitement laser.

15. Procédé suivant l'une quelconque des revendications 12 à 14, caractérisé en ce que, avant la structuration, les lignes de rupture sont formées, et ce par un traitement mécanique ou par un traitement laser.

16. Procédé suivant l'une quelconque des revendications 12 à 15, caractérisé en ce que la structuration est réalisée par une technique de gravure et/ou par traitement mécanique.
